## Europäisches Patentamt

## European Patent Office

## Office européen des brevets

(19)

(11) Veröffentlichungsnummer: **0 223 962**
**B1**

(12) **EUROPÄISCHE PATENTSCHRIFT**

(45) Veröffentlichungstag der Patentschrift:
30.05.90

(51) Int. Cl.⁵: **G11C 11/40**

(21) Anmeldenummer: 86113168.8

(22) Anmeldetag: 24.09.86

(54) Verfahren zum Auffrischen von Daten in einer dynamischen RAM-Speichereinheit, und Steuereinheit zur Durchführung dieses Verfahrens.

(30) Priorität: 30.09.85 DE 3534835
11.07.86 DE 3623472

(43) Veröffentlichungstag der Anmeldung:
03.06.87 Patentblatt 87/23

(45) Bekanntmachung des Hinweises auf die Patenterteilung:
30.05.90 Patentblatt 90/22

(84) Benannte Vertragsstaaten:
AT BE CH DE FR GB IT LI NL SE

(56) Entgegenhaltungen:
EP-A- 0 145 413
DE-A- 2 517 872

ELECTRONIC ENGINEERING, Band 51, Nr. 620,
April 1979, Seiten 95-100, London, GB; M. EVANS:
"Designing with 16k and 64k dynamic RAMs"

(73) Patentinhaber: Siemens Aktiengesellschaft,
Wittelsbacherplatz 2, D-8000 München 2(DE)

(72) Erfinder: Pöhnitzsch, Günter, Dipl.-Ing.,
Preziosastrasse 51, D-8000 München 81(DE)

## Beschreibung

Die Erfindung geht von dim im Oberbegriff des Patentanspruches 1 genannten bekannten Verfahren aus.

Jede Speicherzelle einer solchen RAM-Speichereinheit muß in regelmäßigen Zeitabständen, z.B. nach einer Höchstdauer von 2ms, mittles der von dem Refreshgenerator gesteuerten Refreshzyklen aufgefrischt werden. Andernfalls würden diese Speicherzellen ihre eingespeicherte Information durch Selbstentladung relativ rasch verlieren. Beim Stand der Technik - und auch der Erfindung - kann hierbei im Prinzip ein einziger Refreshgenerator nicht nur eine einzige RAM-Speichereinheit, sondern sogar eine hohe Anzahl verschiedener RAM-Speichereinheiten mit deren individuell benötigten Refreshzyklen versorgen.

Häufig wird nicht die ganze jeweils betroffene RAM-Speichereinheit auf einmal aufgefrischt, sondern in Etappen, nämlich jeweils nur eine kleine Gruppe der Speicherzellen des Speichers, z.B. jeweils nur alle Speicherzellen einer einzigen Speicherzeile oder einer einzigne Speicherspalte einer - z.B. 128 solche Gruppen enthaltenden - matrixartig aufgebauten RAM-Speichereinheit. Zwischen den Etappen können Lese- und Schreibzyklen, also normale Speicherzyklen, durchgeführt werden. Das Auffrischen der gesamten Speichereinheit erfolgt dann nacheinander in vielen einzelnen Refreshzyklen, welche für sich jeweils z.B. nur weit weniger als jeweils 1 µs dauern, mit jeweils lange - z.B. 15 µs - dauernden, für nächste Speicherzyklen benutzbaren Unterbrechungen zwischen diesen Refreshzyklen. Der Zeitabstand zwischen zwei Refreshzyklen beträgt in diesem Falle nämlich z.B. jene Höchstdauer von z.B. 2 ms, dividiert durch die Anzahl der Gruppen von Speicherzellen der betreffenden RAM-Speichereinheit, also z.B. bei einer RAM-Speichereinheit mit 128 Gruppen z.B.

2 ms : 128 = ca. 15 µs.

Die bekannten RAM-Speichereinheiten werden z.B. dadurch aufgefrischt, daß sie von einer zentralen Recheneinheit mittels eines Request-Signals einen Refreshzyklus anfordern und mittels eines Grant-Signals schließlich den Refreshzyklus zugeteilt bekommen.

Bei der Erfindung findet, ebenso wie beim einschlägigen Stand der Technik, nicht zwischen sämtlichen Speicherzyklen 1/2/3/4 ein Refreshzyklus 5 statt. Ein Auffrischen aller Speicherzellen bei jedem Speicherzyklus ist im allgemeinen weder nötig noch ökonomisch neutral. Jeder Refreshzyklus erzeugt nämlich eine relativ starke Belastung der Stromversorgung der RAM-Speichereinheit. Daher wird zwischen zwei von Speicherzyklen ausgelösten Refreshzyklen mindestens eine längere Zeitspanne gelegt, während welcher zwar viele Speicherzyklen 1/2/3/4 stattfinden können, aber keine weiteren Refreshzyklen.

Während der Dauer des Refreshzyklusses wird bei den bekannten RAM-Speichereinheiten kein Zugriff von außen, also z.B. von einem außen angeschlossenen Prozessor, auf die betreffende RAM-Speichereinheit zugelassen, d.h. es wird also kein normaler Speicherzyklus, also weder ein Lesenoch ein · Schreibzyklus, durchgeführt. Normalerweise wird daher diese RAM-Speichereinheit während des Refreshzyklusses g e s p e r r t für das Einleiten von solchen normalen Speicherzyklen. Erst wenn der Refreshzyklus zur Auffrischung der betreffenden Speicherzellen durchgeführt ist, wird diese RAM-Speichereinheit wieder für Zugriffe von außen, also für nächste Lese- und/oder Schreibzyklen, freigegeben.

Die Erfindung vermeidet - zumindest weitgehend - Zeitverluste, welche durch diese bekannte Refreshzyklensteuerung bewirkt werden (und welche je nach dem verwendeten RAM-Speichertyp und je nach der benutzten Frequenz des Systemtaktes z.B. 5 % und viel mehr der Dauer der Abwicklung eines längeren Programmes betragen kann) durch die im Patentanspruch 1 angegebenen Maßnahmen.

Beim Betrieb gemäß der Erfindung sind also zweite Zeitspannen von variabler Länge eingefügt, in welchen normalerweise jeweils der nächste Refreshzyklus zu einem statistisch variierenden Zeitpunkt auftritt. Hierbei entspricht dieser nächste Refreshzyklus jedenfalls angenähert dem sofortigen Beginn einer neuen ersten Zeitspanne. Es zeigte sich nämlich, daß die Pausen zwischen den einzelnen normalen Speicherzyklen lange genug dauern - jedenfalls bei einem Großrechner, wie es die Zentralsteuereinheit eines elektronisch gesteuerten Vermittlungssystemes darstellt - , um den Refreshzyklus hocheffizient und zeitsparend auch noch zwischen zwei normalen, unmittelbar dicht aufeinander folgenden Speicherzyklen ohne Sperren des Zugriffes auf die RAM-Speichereinheit durchführen zu können.

Die Erfindung löst also das Problem der Zeitverlustvermeidung durch eine spezielle Verschachtelung des Refreshzyklusses mit der Pause zwischen normalen Speicherzugriffen, z.B. zwischen zwei Lesezyklen. Weil dann das Sperren der RAM-Speichereinheit für das Einleiten von normalen Speicherzyklen zumindest während der ersten und der zweiten Zeitspannen unnötig ist und also (evtl. sogar während des Not-Refreshzyklusses) unterbleibt, werden durch die Erfindung jene (Verlust-)Zeiten vermieden, die beim Stand der Technik zum Sperren des Zugriffes auf die RAM-Speichereinheit benötigt werden. Damit werden die Zeitverluste für das Auffrischen zumindest weitgehend wenn nicht sogar völlig, z.B. um die oben erwähnten 5 % und mehr der Betriebsdauer des betreffenden Speichers, vermieden.

Die Erfindung bietet also ein einfach betreibbares Verfahren - sogar der Aufwand für das Sperren des Zugriffes kann zumindest weitgehend wegfallen - zum Auffrischen von Daten in einer etappenweise aufzufrischenden dynamischen RAM-Speichereinheit, welcher ein Refreshgenerator mit mindestens einem einzigen Zeitmesser zugeordnet ist. Diese RAM-Speichereinheit weist eine kurze Pause von z.B. 400 ns zwischen einem Speicherzyklusende, also Lesezyklusende und/oder Schreibzyklusende, einerseits und einem unmittelbar dicht darauf folgenden nächstmöglichen solchen Speicherzyklus andererseits auf. Die RAM-Speichereinheit kann hierbei z.B. einen oder mehrere RAM-Halbleiterchips enthalten.

Die Erfindung wurde zwar für eine RAM-Speichereinheit entwickelt und erprobt, welche 128 für sich nacheinander aufzufrischende Gruppen von Speicherzellen enthält und also 128 Refreshzyklen innerhalb einer Gesamt-Höchstdauer von z.B. 2 ms zur etappenweisen Auffrischung aller in ihr enthaltenen Gruppen benötigt. Die Erfindung ist aber generell für alle durch den Patentanspruch 1 definierten RAM-Speichereinheiten verwendbar.

Die in den Unteransprüchen definierten zusätzlichen Maßnahmen gestatten, zusätzlich Vorteile zu erreichen. So gestatten die Maßnahmen gemäß Patentanspruch 2, nur die im Vergleich zu einem Schreibzyklus normalerweise kurz dauernden Lesezyklen in den ersten und zweiten Zeitspannen als Refreshzyklenauslöser zu verwenden, und dadurch selbst dann noch - jedenfalls weitgehend - das erfindungsgemäße Verfahren anwenden zu können, wenn die Schreibzyklen zu lange dauern, um sie als Refreshzyklenauslöser verwenden zu können, sowie gemäß Patentanspruch 3, die zugehörige Steuereinheit in besonders einfacher Weise aufzubauen.

Die Erfindung wird im folgenden anhand der FIGUREN weiter erläutert, welche ein spezielles Beispiel einer Steuereinheit für die Durchführung des Refreshzyklusses einer RAM-Speichereinheit mit z.B. 128 Speicherzeilen bzw. Gruppen betreffen. Bei dem gezeigten Beispiel wird der RAS-Takt (Row address strobe-Takt) zum Auffrischen erfindungsgemäß mit einem Refreshzyklustakt verknüpft, welcher hier im Beispiel die - z.B. eine Speicherzeile (Row) bildende -Gruppe von Speicherzellen auffrischt.

Die Erfindung ist aber auch nicht auf das gezeigte spezielle Steuereinheitbeispiel und auf die gezeigten Zeitverlaufbeispiele beschränkt. Die RAM-Speichereinheit selbst kann also im Prinzip beliebig aufgebaut sein und, abgesehen von den erfindungsgemäß zu erzeugenden Takten, mit zu diesem Aufbau passenden beliebigen sonstigen Takten versorgt sein. Diese RAM-Speichereinheit kann also z.B. auch eine EDC-Sicherung, nämlich z.B. zusätzlich den Baustein Am2960, enthalten.

Es zeigen die FIGUR

1 (im einzelnen an sich in Wahrheit jeweils vom speziellen Aufbau und vom speziellen Betrieb der RAM-Speichereinheit abhängige) Diagrammbeispiele für das Timing der verschiedenen Takte für einen Lesezyklus (bzw. Schreibzyklus) 1/2/3/4 während der ersten Zeitspanne r, in welcher - abgesehen nahe bei dem Beginn dieser Zeitspanne r - kein Refreshzyklus mehr ausgelöst wird, wobei

(a) ein Verlaufbeispiel des von der zentralen Rechnereinheit an die RAM-Speichereinheit gelieferten Starttaktes 1 zeigt, dessen Vorderflanke a' den Start dieses Zyklusses darstellt, wobei hier angenommen ist, daß sofort zum frühestmöglichen Zeitpunkt nach dem ersten Starttakt 1 eines ersten Lesezyklusses ein nächster zweiter Starttakt 1 eines nächsten, zweiten Lesezyklusses an diese RAM-Seichereinheit geliefert würde,

(b) ein refreshzyklusfreies Verlaufbeispiel eines RAS-Taktes (Row address strobe) 2 zeigt,

(c) ein Verlaufbeispiel eines zugehörigen CAS-Taktes (column address strobe) 3 zeigt, und

(d) ein Beispiel für die Zeitdauern 4 zeigt, zu welchen während eines solchen Lesezyklusses - bei Bedarf mittels eines EDC-Code korrigierte - Daten am Ausgang der RAM-Speichereinheit vorliegen können;

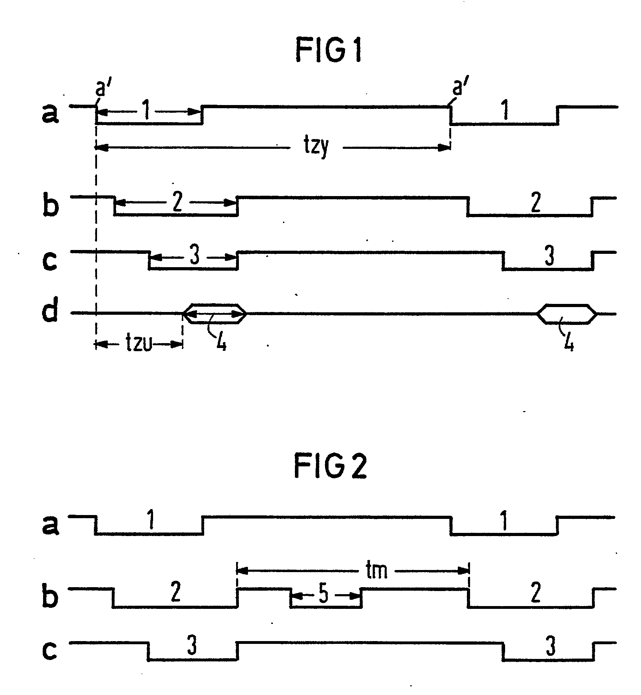

2 die bereits in FIG.1 dargestellten Verläufe (a) bis (c), jedoch nun während der zweiten Zeitspanne s; - dementsprechend ist in den Verlauf (b) ein Beispiel für die Dauer eines Taktes 5 des Refreshzyklusses zeitlich verschachtelt in die Pause zwischen zwei dicht aufeinander folgenden RAS-Takten 2 eingefügt, nämlich zwischen dem Ende eines ersten Lesevorganges 1/2/3/4 und dem Beginn des frühestens möglichen nächsten RAS-Taktes 2 eines nächsten Lesevorganges 1/2/3/4; (um die FIG.2 möglichst einfach zu gestalten, ist in FIG.2 der Verlauf (d) nicht mehr wiederholt; er ist nämlich, trotz des in (b) eingefügten Taktes 5 des Refreshzyklusses, identisch wie in FIG.1, bezogen auf die Takte 1 und 2);

3 wichtige Teile eines speziellen, den Refreshgenerator steuernden Steuereinheitbeispieles; sowie

4 Beispiele für die Verläufe der verschiedenen Zeitspannen, vor allem der ersten Zeitspanne r und der zweiten Zeitspanne s.

Beim beschriebenen Beispiel beträgt die Dauer tzy zwischen den Beginnzeitpunkten a' zweier dichtest aufeinander folgendert Lese- oder Schreibzyklen jeweils ca. 1 μs, vgl. FIG.1 und 2. Der Leseausgang der RAM-Speichereinheit liefert dann also bereits während der Dauer 4 die gelesenen - z.B. bereits ECD-korrigierten - Daten, und zwar liefert er diese Daten schon nach der kurzen, in FIG.1 gezeigten Zugriffszeit tzu, welche z.B. 440 ns beträgt.

Nachdem die Daten aus der RAM-Speichereinheit ausgelesen sind, hat die RAM-Speichereinheit eine Ruhezeit tm, vgl. FIG.2, einzuhalten, die zumindest gleich lang ist wie die vom RAM-Speichereinheit-Hersteller vergegebene (Mindest-) Ruhezeit tr, die aber - vor allem bei Großspeichern der Zentralsteuereinheiten der Vermittlungstechnik wegen der hohen Signallaufzeiten auf den dort besonders langen Leitungen - ganz erheblich länger ist als die vom RAM-Speichereinheit-Hersteller vorgeschriebene (Mindest-)Ruhezeit tr.

Weil also besonders bei Großspeichern der Vermittlungstechnik, z.B. in einem EWSD-Fernsprechvermittlungssystem, die betreffende Pause tm länger als die erforderliche Dauer des Refreshzyklusses 5 ist, kann in einer solchen Pause tm, also sogar unmittelbar zwischen zwei dicht aufeinander folgenden Speicherzyklen, der erforderliche Refreshzyklus 5 auch ohne Sperren des Zugriffes auf die RAM-Speichereinheit stattfinden. Bei der Erfindung wird also diese bei Normalbetrieb einer RAM-Speichereinheit im allgemeinen ausreichend lange dauernde Pause tm zum Auffrischen mitausgenutzt.

Bei der Erfindung startet also im Prinzip zunächst jeder, genannt erster, Speicherzyklus 1/2/3/4 - genau genommen in diesem Beispiel die Vorderflanke a' seines Starttaktes 1 - sofort, nämlich noch in der Pause vor dem frühestmöglichen nächsten Speicherzyklus 1/2/3/4, einen noch vor dem Beginn a' dieses nächsten Speicherzyklusses abgeschlossenen, ersten Refreshzyklus 5. Innerhalb einer - angenähert mit diesem Refreshzyklus 5, z.B. durch Rücksetzen des betreffenden Zeitmessers, beginnenden - ersten Zeitspanne r, welche z.B. 10 µs dauert, vgl. FIG.1, 2 und 4, und welche deutlich länger als die minimale Dauer von z.B. 1 µs zwischen den Beginnzeitpunkten a' zweier aufeinander folgender Speicherzyklen bzw. zweier aufeinander folgender Starttakte 1 ist, vgl. FIG.1 und 2, löst jedoch nach dem Ende des ersten Refreshzyklusses 5 jeder weitere Starttakt 1 keinen weiteren Refreshzyklus 5 aus.

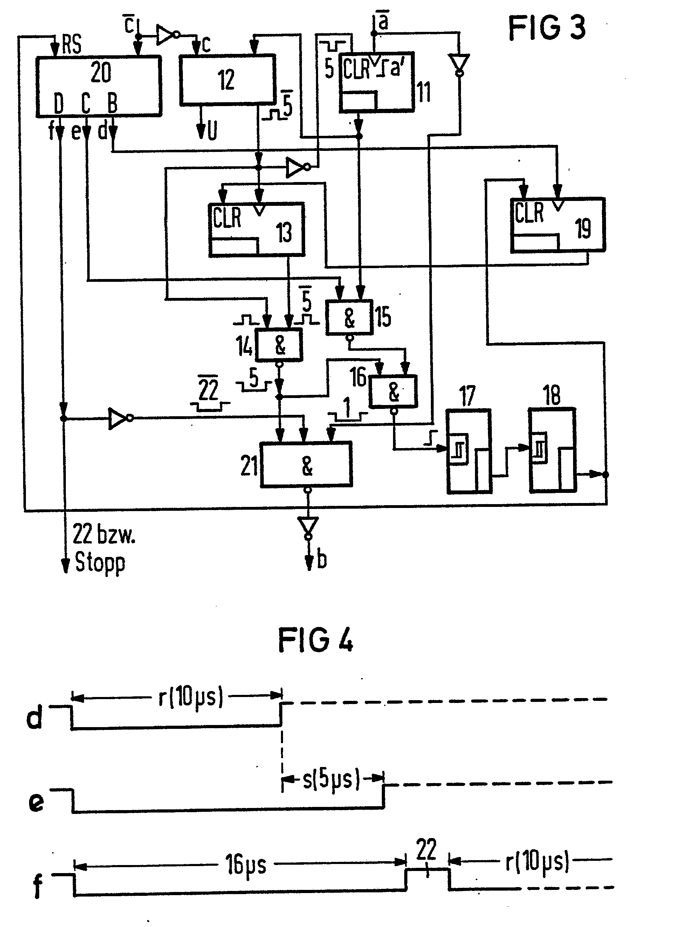

Erfindungsgemäß ist nach der ersten Zeitspanne r die zweite Zeitspanne s eingefügt, welche z.B. von minimal 0 bis maximal 5 µs dauert und welche nach dem Ende der zuletzt abgelaufenen ersten Zeitspanne r auftritt. Erst ein, vgl. FIG.4, in dieser zweiten Zeitspanne s, also z.B. 2 µs nach dem Ende der zuletzt abgelaufenen ersten Zeitspanne r, auftretender nächster, genannt x-ter, Starttakt 1 eines Speicherzyklusses wirkt jeweils wieder in gleicher Weise wie der erste Starttakt 1 des ersten Speicherzyklusses, indem er - noch vor dem möglichen Beginn a' eines dann frühestmöglichen nächsten x+1-ten Starttaktes 1 eines Speicherzyklusses 1/2/3/4 - einen nächsten, noch vor diesem möglichen Beginn a' dieses x+1-ten Speicherzyklusses 1/2/3/4 abgeschlossenen Refreshzyklus 5 auslöst, wobei dieser nächste Refreshzyklus 5 wieder, in gleicher Weise wie schon oben beschrieben, den Beginn einer neuen ersten Zeitspanne r von z.B. 10 µs auslöst - und zwar z.B. indem dieser Starttakt 1 oder ein davon unmittelbar oder mittelbar abgeleiteter Takt, z.B. der Refreshzyklus-Takt 5 oder ein abgeleitetes Rücksetzsignal, den Zeitmesser entsprechend neu einstellt.

Falls aber in der zweiten Zeitspanne s von z.B. 5 µs kein x-ter Speicherzyklus mittels eines Starttakts 1 gestartet wurde, also auch kein nächster Refreshzyklus 5 durch einen solchen x-ten Speicherzyklus gestartet wurde, dann wird auch unabhängig vom Vorliegen eines x-ten Speicherzyklusses der nächste Refreshzyklus 5 als Not-Refreshzyklus 5 zwangsweise - z.B. unmittelbar vom Refreshgenerator, z.B. von dessen Zeitmesser mittels des Impulses bzw. Taktes 22 - ausgelöst. Durch diesen zwangsweise, z.B. in der 16ten µs, vgl. FIG.4, gestarteten Not-Refreshzyklus 5 wird verhindert, daß die in der betreffenden RAM-Speichereinheitgruppe (z.B. Row) gespeicherten Informationen durch zu spätes Auffrischen verloren gehen.

In Sonderfällen kann dieser aus Zeitnot zwangsweise, nämlich ohne einem unmittelbar vorhergehenden Speicherzyklus 1/2/3/4 gestartete Not-Refreshzyklus 5 auch unter gleichzeitiger Sperrung dieser betroffenen RAM-Speichereinheit für einen Lese- oder Schreibzyklus durchgeführt werden, was dann allerdings einen evtl. vermeidbaren Zeitverlust bewirken kann. Nach Möglichkeit sollte man also auch dann den Not-Refreshzyklus 5 zeitlich so legen - sozusagen so in die theoretisch denkbare Pause tm vor einem nächstmöglichen Speicherzyklus 1/2/3/4 legen, daß der betreffende Not-Refreshzyklus 5 mit Sicherheit noch vor dem Beginn des nächstmöglichen Speicherzyklusses 1/2/3/4 mit Sicherheit bereits abgeschlossen ist und daß daher ein Sperren des Zugriffes auch hierbei unterlassen werden kann.

Weil Lesezyklen 1/2/3/4 häufig kürzer dauern als Schreibzyklen 1/2/3/4 - selbst wenn zur Sicherung der Daten ein EDC-Code verwendet wird - , dauern normalerweise die Pausen tm nach einem Lesezyklus 1/2/3/4 länger als die Pausen nach einem Schreibzyklus 1/2/3/4. Daher wird der erfindungsgemäß eingefügte Refreshzyklus 5 bevorzugt von einem Lesezyklus 1/2/3/4 der RAM-Speichereinheit ausgelöst.

Die FIG.3 zeigt beispielhaft ein Schaltschema für eine Steuereinheit, welche in erfindungsgemäßer Weise den (wegen der Übersichtlichkeit hier nicht gezeigten) Refreshgenerator der (wegen der Übersichtlichkeit hier ebenfalls nicht gezeigten) RAM-Speichereinheit steuert. C bzw. dessen Inversion $\bar{C}$ stellt einen Systemtakt (z.B. eines großen Arbeitsspeichers oder z.B. einer Zentralsteuereinheit eines elektronisch gesteuerten Vermittlungssystemes) dar, welcher mindestens eine einzige solche, regelmäßig etappenweise aufzufrischende RAM-Speichereinheit taktet.

Dieser Systemtakt C, der z.B. eine Impulsfolge mit 1 MHz darstellt, steuert hier einen Zeitmesser 20, der z.B. durch einen 4-Bit-Zähler mit entsprechendem nachgeschalteten Umcodierer oder durch einen entsprechenden, anders aufgebauten Timer gebildet sein kann, damit er z.B. an eigenen Ausgängen A B und D passende Verläufe, z.B. die in FIG.4 gezeigten 10 µs-, 15 µs-und 16 µs-Takte entsprechend den verschiedenen Verläufen d, e und f erzeugt, vgl. auch die Hinweiszeichen an den Ausgängen B, C und D in FIG.3. Diese Verläufe d, e und f wirken im gezeigten Beispiel zunächst auf die Kippstufe 19 bzw. auf die UNDglieder 15 und 21 - streng genommen wirkt auf das UNDglied 21 die Inversion $\overline{22}$ des (im Verlauf f nach dem Ende der zweiten Zeitspanne s, hier also in der 16ten µs nach Beginn der ersten Zeitspanne r auftretenden) Not-Refreshzyklus-Taktes 22. Die Kippstufe 19 kann z.B. durch einen Baustein des Typs 7474 gebildet sein, sowie das UNDglied 15 durch einen Baustein des Typs 7400 sowie das UNDglied 21 durch einen Baustein des Typs 7410.

Der Systemtakt C steuert ferner ein Verzögerungsglied 12, z.B. ein passendes Schieberegister 12. Dieses Schieberegister 12 kann z.B. durch einen Baustein des Typs 74LS194 gebildet sein.

Die Kippstufe 11 wird von dem Verlauf a, genauer gesagt von dessen Inversion $\bar{a}$, gesteuert, also

von den Starttakten $\overline{1}$, vgl. auch FIG.1 und 2. Das Verzögerungsglied 12 erzeugt aus dem der Kippstufe 11 zugeführten Starttakt 1 bzw. $\overline{1}$ eines jeden Speicherzyklusses 1/2/3/4, genauer gesagt aus dessen jeweiliger Vorderflanke a', getaktet durch den Systemtakt C den exakt passend verzögerten Refreshzyklus-Takt 5, und zwar dessen Inversion $\overline{5}$. Die Kippstufe 11 kann z.B. durch einen Baustein des Typs 7474 gebildet sein.

Der (mittels des Verzögerungsgliedes 12 aus der StarttaktVorderflanke a' passend verzögert) mit exakter Verzögerung erzeugte Refreshzyklus-Takt 5 bzw. $\overline{5}$ wird - in Wahrheit eigentlich nochmals durch Laufzeiten verzögert - über die Kippstufe 13 und über das UNDglied 14 den UNDgliedern 16 und 21 zugeleitet, außerdem auch dem Takteingang der Kippstufe 11. Dem UNDglied 21 wird außerdem der jeweilige Starttakt 1 zugeleitet. Am Ausgang des UNDgliedes 21 entsteht daher schließlich durch entsprechende Überlagerungen der Verlauf b von FIG.1, wenn kein Takt 5 vorliegt, aber der Verlauf b von FIG.2, wenn der Takt 5 vorliegt. Die Kippstufe 13 kann z.B. durch einen Baustein des Typs 7474 gebildet sein, sowie die UNDglieder 14 und 16 jeweils durch Bausteine des Typs 7400.

Das Verzögerungsglied (Schieberegister) 12 kann auch noch andere Takte liefern, - z.B. nach jedem Refreshzyklus 5 noch einen Takt U, um ihn dem Refreshgenerator zur Umschaltung auf die nächste Refreshadresse zu liefern.

Erfindungsgemäß sind die beiden verschiedenen Betriebsarten in den beiden Zeitspannen r und s vorgesehen, wobei während der ersten Zeitspanne r - nach dem bei Beginn der ersten Zeitspanne r durchgeführten ersten Refreshzyklus 5 bzw. $\overline{5}$ - entsprechend dem Verlauf b in FIG. 1 keine weiteren Refreshzyklen 5 bzw. $\overline{5}$ mehr durchgeführt werden, sondern erst wieder in der zweiten, variabel langen Zeitspanne s nach einem Speicherzyklus 1/2/3/4 entsprechend dem Verlauf b in FIG. 2. Dadurch werden die Speicherzellen nicht unnötigerweise viel zu oft aufgefrischt, und es werden auch unnötige Belastungen der Stromversorgung des Refreshgenerators und der RAM-Speichereinheit vermieden.

Damit am Ausgang des UNDgliedes 21 in der ersten Zeitspanne s, die z.B. 10 μs dauert, nach dem ersten Refreshzyklus 5 bzw. $\overline{5}$ kein weiterer Refreshzyklus-Takt 5 bzw. $\overline{5}$ mehr erzeugt wird, wird die Kippstufe 19 vom Zeitmesser 20 gemäß dem Verlauf d von FIG.4 gesteuert. Daher wird sofort nach dem ersten durchgeführten Refreshzyklus die Kippstufe 13 für die ganze restliche Dauer der ersten Zeitspanne r mittels des Ausgangssignales der Kippstufe 19 über den CLR-Eingang der Kippstufe 13 gesperrt, so daß dann am Ausgang der Kippstufe 13 während dieser restlichen Dauer der ersten Zeitspanne r kein Refreshzyklus-Takt 5 bzw. $\overline{5}$ mehr entstehen kann.

Nach dieser ersten Zeitspanne r beginnt die zweite Zeitspanne s, welche variabel ist und also z.B. zwischen 0 bis 5 μs dauern kann und in welcher ein Speicherzyklus 1/2/3/4 sofort wieder einen Refreshzyklus 5 bzw. $\overline{5}$ auslösen soll. Daher wird ab dem Beginn dieser zweiten Zeitspanne s eine angenähert der Differenz der Verläufe d und e entsprechende Signalkombination dem UNDglied 21 geliefert. Dazu wird im gezeigten Beispiel der Verlauf e vom Zeitmesser 20 über dessen Ausgang C und über die Einheiten 15, 16, 17 und 18 der Kippschaltung sowie der Verlauf d vom Zeitmesser 20 über dessen Ausgang B der Kippstufe 19 zugeleitet und damit die Kippstufe 13 bei Beginn der zweiten Zeitspanne s rückgesetzt. Nun ist der Refreshzyklus 5 bzw. $\overline{5}$ in der Pause tm durch den Starttakt 1 eines Speicherzyklusses auslösbar:

Wird nämlich nun ein Speicherzyklus, z.B. Lesezyklus 1/2/3/4, gestartet, also über die Kippstufe 11 und das Verzögerungsglied 12 ein passend verzögerter Refreshzyklus-Takt $\overline{5}$ erzeugt, dann kann die Kippstufe 13 wieder schalten - es entsteht an den Ausgängen der UNDglieder 14 und 21 wieder ein Refreshzyklus-Takt 5 bzw. $\overline{5}$ für einen neuen Refreshzyklus. - Hierbei wird übrigens zusätzlich die Kippstufe 19 über das UNDglied 15 und, mit dem Ende des Taktes 5, über das UNDglied 16 sowie über die - z.B. durch Bausteine des Typs 74221 gebildete - Kippstufen 17 und 18 rückgesetzt. Damit wird aber am Ausgang der Kippstufe 19 ein Rücksetzsignal RS erzeugt, welches den Zeitmesser 20 rücksetzt, so daß nun wieder eine neue erste Zeitspanne r von z.B. 10 μs beginnt. Bei diesem Beispiel löst also der betreffende Starttakt 1 nahezu sofort das Ende der betreffenden zweiten Zeitspanne s und damit nahezu sofort den (Neu-)Beginn einer folgenden ersten Zeitspanne r aus. Weitere Speicherzyklen 1/2/3/4 können daher nun - wieder für die Dauer dieser vom Zeitmesser 20 festgelegten ersten Zeitspanne r - keinen weiteren Refreshzyklus-Takt 5 bzw. $\overline{5}$ mehr auslösen, sondern nur noch Verläufe wie in FIG.1.

Wenn jedoch innerhalb der zweiten Zeitspanne s, also nach dem Rücksetzen der Kippstufe 19, kein Speicherzyklus 1/2/3/4, also z.B. kein Lesezyklus 1/2/3/4, auftrat, dann wird die Kippstufe 19, diesmal über den vom Zeitmesser 20 gelieferten Verlauf e - also im hier gewählten Beispiel ca. 16 μs nach dem Beginn a' der letzten vorhergehenden ersten Zeitspanne r - sowie über die UNDglieder 15 und 16, sowie über die Kippstufen 17 und 18 - leicht verzögert bis angenähert zum Beginn der nächsten ersten Zeitspanne r - rückgesetzt, wonach die Kippstufe 13 in der anschließend folgenden ersten Zeitspanne r keinen Refreshzyklus-Takt 5 bzw. $\overline{5}$ mehr an das UNDglied 21 liefern kann. Mit ungefähr derselben Verzögerung setzt die Kippstufe 18 mittels des Rücksetzsignales RS auch den Zeitmesser 20 zurück. Damit ist gesichert, daß nach dem Ende der letzten zweiten Zeitspanne s - mit einer leichten Verzögerung - wieder eine erste Zeitspanne r von vorne beginnt. Zwischen der letzten zweiten Zeitspanne s und der folgenden neuen ersten Zeitspanne r löst das gezeigte Beispiel jedoch nun noch den Not-Refreshzyklus über seinen Ausgang "Stopp" aus:

In dieser kurzen Zwischenzeit zwischen der letzten zweiten und der folgenden ersten Zeitspanne liefert nämlich der Zeitmesser 20 über seinen Ausgang D den Verlauf f, d.h. er liefert selbst den Not-Refreshzyklus-Takt 22 an der Klemme "Stopp", wo-. bei dieser dorthin gelieferte Takt 22 nun im Refreshgenerator den Not-Refreshzyklus auslöst. Zusätzlich kann dann bei Bedarf dieser vom Zeitmesser 20 gelieferte Takt 22 bzw. $\overline{22}$ in für sich bekannter Weise auch zum Sperren des Zugriffes auf die RAM-Speichereinheit verwendet werden. Die Inversion $\overline{22}$ dieses Taktes wird außerdem dem UNDglied 21 geliefert, wodurch dieses UNDglied 21 für die Dauer dieses Taktes $\overline{22}$ zuverlässig gesperrt wird, wodurch es also vorübergehend an seinem Ausgang kein Signal abgeben kann. Erst wenn der Takt 22 vorbei ist, kann das UNDglied 21 wieder die Starttakte 1 und die während der ersten und zweiten Zeitspannen r, s erzeugten Refreshzyklus-Takte 5 bzw. $\overline{5}$ als Verläufe b gemäß FIG. 1 und 2 weiterleiten. Eine Besonderheit dieses an der Klemme "Stopp" abnehmbaren Not-Refreshzyklus-taktes 22 ist, daß er den Refreshzyklus zwangsweise, also ohne auslösendem Starttakt 1, ausgelöst.

Versuche an einem Rechner vom Typ SSP 112 D und SSP 112 R in der Zentralsteuereinheit eines elektronischen EWSD-Fernsprech-Vermittlungssystems mit einer Vielzal von erfindungsgemäß betriebenen RAM-Speichereinheiten in einem RAM-Arbeitsspeicher zeigten, daß nur sehr selten ein Refreshzyklus zwangsweise durchgeführt werden mußte, besonders wenn dort der im betreffenden RAM-Arbeitsspeicher abgespeicherte Programmcode laufend gelesen werden mußte. Lediglich bei erneuter Inbetriebnahme dieses RAM-Arbeitsspeichers nach einem Stromausfall wurden vorübergehend kurzzeitig viele Refreshzyklen zwangsweise nötig, da vorübergehend größere Pausen im Speicherbetrieb, d.h. besonders beim Lesen des abgespeicherten Programmcodes auftraten. Der durch die Erfindung erreichte Zeitgewinn hat im Normalbetrieb hierbei meistens rund 5 % der Betriebszeit erreicht, d.h. der Rechner bzw. die Zentralsteuereinheit konnte bei Spitzenbelastung rund 5 % mehr Vermittlungsfunktionen als ohne die erfindungsgemäßen Maßnahmen durchführen, und zwar nahezu ohne besonderen zusätzlichen Hardwareaufwand oder Softwareaufwand für diesen außerordentlich großen Rechner der Zentralsteuereinheit.

**Patentansprüche**

1. Verfahren zur Steuerung des Auffrischens von Daten in einer dynamischen RAM-Speichereinheit.
# z.B. in RAM-Großspeichereinheiten der Zentralsteuereinheit eines elektronischen Vermittlungssystemes, bei dem die Zentralsteuereinheit zwischen ihren vielen Baueinheiten relativ viele lange Verdrahtungen mit hohen Laufzeiten aufweist,

- welche mehrere Gruppen von Speicherzellen aufweist, wobei jede Gruppe für sich innerhalb eines eigenen Refreshzyklus aufgefrischt wird, und zwischen zwei aufeinanderfolgenden Refreshzyklen normale Speicherzyklen (1/2/3/4), also Lese- und/oder Schreibzyklen, durchgeführt werden können,
- welche einen, die für das Auffrischen jeweils nötigen Refreshspannungen erzeugenden, Refreshgenerator mit mindestens einem einzigen Zeitmesser (20) zur Messung von Zeitspannen (r, s bzw. d, e, f) enthält,
- welche eine kurze Pause(tm) - von z.B. 400 ns - zwischen dem Ende eines Speicherzyklus (1/2/3/4), z.B. Lesezyklus oder Schreibzyklus, einerseits und einem unmittelbar dicht darauf folgenden nächstmöglichen solchen Speicherzyklus andererseits aufweist,
# und welch z.B. einen oder mehrere RAM-Halbleiterchips enthalten kann;
# z.B. für eine maximal 128 für sich nacheinander aufzufrischende Gruppen von Speicherzellen enthaltende RAM-Speichereinheit, welche dann also 128 Refreshzyklen innerhalb einer Höchstdauer von z.B. 2 ms zur Auffrischung aller in ihr enthaltenen Gruppen benötigt,
dadurch gekennzeichnet, daß - die Steuerung während der Zeitdauer - von z.B. 10 bis 16 µs - zwischen zwei aufeinanderfolgenden Refreshzyklen (5) in besonderer Weise in einer ersten Zeitspanne(r) - von z.B. 10 µs - anders betrieben wird als in einer darauf folgenden zweiten Zeitspanne(s) - von z.B. ca. 0 bis 5 µs - , nämlich:
- angenähert bei Beginn der ersten Zeitspanne(r) ein erster Speicherzyklus (1/2/3/4)
# nämlich z.B. mittels einer Verzögerungsschaltung (12, 13, 14, 21), die aus der Vorderflanke(a') des Starttaktes (1) des ersten Speicherzyklus (1/2/3/4) einen den Refreshgenerator steuernden verzögerten Takt(5) zur Durchführung des Refreshzyklus (5) erzeugt,
einen, genannt ersten, noch in der genannten Pause(tm) vor dem möllichen Beginn(a') eines frühestmöglichen nächsten Speicherzyklus (1/2/3/4) abgeschlossenen Refreshzyklus (5) auslöst,
- aber nach diesem ersten Refreshzyklus (5) innerhalb der ersten Zeitspanne(r),
* welche deutlich länger als die minimale Dauer(tzy) - von z.B. 1 µs - zwischen den Beginnzeitpunkten(a') zweier unmittelbar aufeinander folgender Speicherzyklen (1/2/3/4) ist,
jeder weitere Speicherzyklus (1/2/3/4) keinen weiteren Refreshzyklus(5) auslöst,
- nach Beginn der zweiten Zeitspanne(s) ein innerhalb dieser zweiten Zeitspanne(s) - also z.B. 2 µs nach dem Ende der zuletzt abgelaufenen ersten Zeitspanne(r) -auftretender nächster, genannt x-ter Speicherzyklus (1/2/3/4) wie der erste Speicherzyklus (1/2/3/4) einen nächsten, noch in der genannten Pause(tm) noch vor dem möglichen Beginn(a') eines frühestmöglichen x+1-ten Speicherzyklus (1/2/3/4) abgeschlossenen Refreshzyklus (5) auslöst,
* wobei dann jener x-te Speicherzyklus (1/2/3/4) - z.B. der Beginn(a') seines Starttaktes (1) - oder ein davon abgeleiteter Takt (5, RS) - z.B. also der von ihm ausgelöste nächste Refreshzyklus (5) - durch Einwirkung (RS) auf den betreffenden Zeitmesser (20) den Beginn einer neuen ersten Zeitspanne(r) - von z.B. 10 µs -auslöst, so daß nach jenem nächsten Refreshzyklus(5) innerhalb der neuen ersten Zeitspanne(r)
# nämlich z.B. mittels eines auf den Zeitmesser(20) wirkenden Rücksetzimpulses (RS)
jeder weitere Speicherzyklus (1/2/3/4) keinen weiteren Refreshzyklus (5) auslöst,
- aber, falls in der zweiten Zeitspanne(s) kein x-ter Speicherzyklus (1/2/3/4) und daher auch kein nächster Refreshzyklus (5) durchgeführt wurde, rasch anschließend - also z.B. 16 µs nach dem Beginn(a') der letzten ersten Zeitspanne(r) - trotz des Fehlens des x-ten Speicherzyklus (1/2/3/4) zwangsweise ein nächster Refreshzyklus (5), also ein Not-Refreshzyklus (5), sowie der Beginn einer nächsten ersten Zeitspanne(r) - von z.B. 10 µs - ausgelöst wird.

2. Verfahren nach Patentanspruch 1, dadurch gekennzeichnet, daß - der einen Refreshzyklus (5) startende Speicherzyklus (1/2/3/4) stets ein Lesezyklus (1/2/3/4) ist.

3. Steuereinheit zur Durchführung des Verfahrens nach Patenstanspruch 1 oder 2 dadurch gekennzeichnet, daß - der Zeitmesser(20) ein von einem Systemtakt (C) gesteuerter, durch ein Rücksetzsignal (RS) rücksetzbarer Taktimpulszähler (20) ist, der
* sowohl die erste Zeitspanne(r) - z.B. von 10 µs -
* als auch die sweite Zeitspanne(s) - z.B. von 5 µs - festlegt und von jedem mit einem Refreshzyklus (5) korrelierenden Rücksetzimpuls (RS) rückgesetzt wird.

**Claims**

1. Method of controlling the refreshing of data in a dynamic RAM memory unit,
# for example in RAM large-scale memory units of the central control unit of an electronic switching system, in which the central control unit has relatively many, long connections with high running times between its many components,
- which has a plurality of groups of memory cells, each group being refreshed for itself within an own refresh cycle, and normal memory cycles (1/2/3/4), that is read and/or write cycles, can be executed between two successive refresh cycles,
- which contains a refresh generator for generating refresh voltages, respectively required for refreshing, with at least a single timer (20) for measuring time intervals (r, s and d, e, f)
- which has a short pause (tm) - of for example 400 ns - between the end of a memory cycle (1/2/3/4), for example a read cycle or a write cycle, on the one hand and a next possible such memory cycle following immediately thereafter in close proximity on the other hand,
# and which may contain, for example, one or more RAM semiconductor chips;
# for example for a RAM memory unit containing a maximum of 128 groups of memory cells to be successively refreshed for themselves, which unit thus requires 128 refresh cycles within a maximum duration of, for example, 2 ms for refreshing all groups contained in it, characterized in that
- the control during the time duration - of for example 10 to 16 µs - between two successive refresh cycles (5) is differently managed in a special manner in a first time interval (r) - of for example 10 µs - than in a second time interval (s) - of for example about 0 to 5 µs - following thereon, namely:
- at approximately the beginning of the first time interval (r), a first memory cycle (1/2/3/4) triggers a refresh cycle (5), referred to as a first refresh cycle,
# namely for example by means of a delay circuit (12, 13, 14, 21), which generates the leading edge (a') of the start clock (1) of the first memory cycle (1/2/3/4) a delayed clock (5), controlling the refresh generator, for execution of the refresh cycle (5), concluded while still in the said pause (tm) before the possible beginning (a') of an earliest possible next memory cycle (1/2/3/4),
- but after the said first refresh cycle (5) within the first time interval (r),
* which is clearly longer than the minimum duration (tzy) - of for example 1 µs - betwen the beginning times (a') of two immediately successive memory cycles (1/2/3/4),
each further memory cycle (1/2/3/4) does not trigger any further refresh cycle (5),
- after the beginning of the second time interval (s) a next memory cycle (1/2/3/4), referred to as the xth memory cycle, occurring within the said second time interval (s) - that is for example 2 µs after the end of the most recently expired first time interval (r) - like the first memory cycle (1/2/3/4) triggers a next refresh cycle (5) concluded while still in the said pause (tm) still before the possible beginning (a') of an earliest possible x+1th memory cycle (1/2/3/4),
* the said xth memory cycle (1/2/3/4) - for example the beginning (a') of the start clock (1) thereof - or a clock (5, RS) derived therefrom - that is for example the next refresh cycle (5) triggered by it - then triggering the beginning of a new first time interval (r) - of for example 10 µs - by acting (RS) on the appertaining timer (20), so that after the said next refresh cycle (5) within the new first time interval (r),
# namely for example by means of a reset (RS) acting on the timer (20),
every further memory cycle (1/2/3/4) triggers no further refresh cycle (5),
- but, in the event that no xth memory cycle (1/2/3/4) was executed in the second time interval (s), and therefore also no next refresh cycle (5), a next refresh cycle (5), i.e. an emergency refresh cycle (5), is automatically triggered quickly thereafter — that is for example 16 µs after the beginning (a') of the last first time interval (r) - in spite of the absence of the xth memory cycle (1/2/3/4) - and the beginning of a next first time interval (r) - of for example 10 µs - is also triggered.

2. Method according to patent claim 1, characterized in that the memory cycle (1/2/3/4) starting a refresh cycle (5) is always a read cycle (1/2/3/4).

3. Control unit for executing the method according to patent claim 1 or 2, characterized in that the timer (20) is a clock pulse counter (20), which is controlled by a system clock (C), can be reset by a reset signal (RS) and fixes
* both the first time interval (r) - for example of 10 µs -
* and the second time interval (s) - for example of 5 µs - and is reset by each reset pulse (RS) correlating with a refresh cycle (5).

## Revendications

1. Procédé pour commander le rafraîchissement de données dans une unité de mémoire RAM dynamique,
# par exemple dans des unités de mémoire RAM de grandes dimensions de l'unité centrale de command d'un système de commutation électronique, dans lequel l'unité centrale de commande comporte, entre ses nombreux modules, des câblages relativement longs, dans lesquels les temps de transit sont élevés,
— qui comporte plusieurs groupes de cellules de mémoire, chaque groupe étant rafraîchi en soi à l'intérieur d'un cycle de rafraîchissement, et des cycles normaux de mémoire (1/2/3/4), c'est-à-dire des cycles de lecture et/ou d'enregistrement, pouvant être exécutés entre deux cycles successifs de rafraîchissement,
— qui contient un générateur de rafraîchissement qui produit des tensions de rafraîchissement respectivement nécessaires pour le rafraîchissement et comporte au moins une minuterie unique (20) servant à la mesure d'intervalles de temps (r, s ou d, e, f) et
— dans laquelle il existe une courte pause (tm) - égale par exemple à 400 ns - entre la fin d'un cycle de mémoire (1/2/3/4), par exemple un cycle de lecture ou un cycle d'enregistrement, d'une part et un tel cycle de mémoire intervenant immédiatement à la suite dudit cycle,
# et qui peut contenir par exemple une ou plusieurs microplaquettes à semiconducteurs RAM;
# par exemple pour une unité de mémoire RAM, qui contient au maximum 128 groupes, qui doivent être en soi rafraîchis successivement de cellules de mémoire et requiert alors par conséquent 128 cycles de rafraîchissement au cours d'une durée maximale de par exemple 2 ms pour le rafraîchissement de tous les groupes contenus dans la mémoire, caractérisé par le fait que
— la commande pendant la durée - de par exemple 10 à 16 µs - entre deux cycles successifs de rafraîchissement (5) s'effectue d'une manière particulière dans un premier intervalle de temps (r) - de par exemple 10 µs - autrement que dans un second intervalle de temps (s) - de par exemple environ 0 à 5 µs - qui lui succède, c'est-à-dire que:
— approximativement au début du premier intervalle de temps (r), un premier cycle de mémoire (1/2/3/4) déclenche
# en effet par exemple au moyen d'un circuit de retardement (12/13/14/21) qui produit, à partir du flanc avant (a') de l'impulsion de cadence de démarrage (1) du premier cycle de mémoire (1/2/3/4), une impulsion de cadence retardée (5), qui commande le générateur de rafraîchissement, pour l'exécution du cycle de rafraîchissement (5),
— un cycle de rafraîchissement (5), désigné comme étant le premier cycle de rafraîchissement, se terminant encore pendant ladite pause (tm) avant début éventuel (a') d'un cycle de mémoire immédiatement suivant (1/2/3/4),
— mais, après ce premier cycle de rafraîchissement (5), à l'intérieur du premier intervalle de temps (r),
* qui est nettement plus long que la durée minimale (tzy) - de par exemple 1 µs - entre les instants de démarrage (a') de deux cycles de mémoire (1/2/3/4), qui se succèdent directement, chaque cycle suivant de mémoire (1/2/3/4) ne déclenche aucun autre cycle de rafraîchissement (5),
— au début du second intervalle de temps (s), - un cycle suivant de mémoire (1/2/3/4), désigné comme étant le x-ème cycle de mémoire, qui apparaît pendant ce second intervalle de temps (s) - c'est-à-dire par exemple 2 µs après la fin du premier intervalle de temps (r) qui s'est écoulé en dernier-, déclenche un cycle de rafraîchissement (5) immédiatement suivant, qui se termine encore pendant ladite pause (tm) encore avant l'éventuel début (a') d'un x+1-ème cycle de mémoire (1/2/3/4) arrivant aussi tôt que possible,
* auquel cas chaque x-ème cycle de mémoire (1/2/3/4) - par exemple le début (a') de son impulsion de cadence de démarrage (1) - ou une première impulsion de cadence (5, RS) qui en est dérivée - c'est-à-dire par exemple le cycle de rafraîchissement (5) immédiatement suivant déclenché par cette impulsion- déclenche -au moyen d'une action (RS) sur la minuterie considérée (20) - le début d'un nouveau premier intervalle de temps (r) - de par exemple 10 µs-, de sorte qu'après chaque cycle immédiatement suivant de rafraîchissement (5), à l'intérieur du nouveau premier intervalle de temps (t),
# à savoir par exemple à l'aide d'une impulsion de remise à l'état initial (RS) agissant sur la minuterie (20), chaque autre cycle de mémoire (1/2/3/4) ne déclenche aucun autre cycle de rafraîchissement (5),
— mais, dans le cas où au cours du second intervalle de temps (s) aucun x-ème cycle de mémoire (1/2/3/4) et par conséquent également aucun cycle immédiatement suivant de rafraîchissement (6) n'ont été exécutés, très rapidement après - c'est-à-dire par exemple 16 µs après le début (a') du dernier premier intervalle de temps (r) - impérativement un cycle immédiatement suivant de rafraîchissement (5), c'est-à-dire un cycle de rafraîchissement d'urgence (5), ainsi que le début d'un premier intervalle de temps immédiatement suivant (r) - de par exemple 10 µs-sont déclenchés, en dépit de l'absence du x-ème cycle de mémoire (1/2/3/4).

2. Procédé suivant la revendication 1, caractérisé par le fait que
— le cycle de mémoire (1/2/3/4), qui déclenche un cycle de rafraîchissement (5), est toujours un cycle de lecture (1/2/3/4).

3. Unité de commande pour la mise en œuvre du procédé selon la revendication 1 ou 2, caractérisé en ce que
— la minuterie (20) est un compteur d'impulsions de cadence (20) commandé par une cadence système (C) et pouvant être amenée à l'état initial par un signal de remise à l'état initial (RS), qui fixe
*   aussi bien le premier intervalle de temps (r) - par exemple de 10 µs-
* que le second intervalle de temps (s) - par exemple de 5 µs- et
est ramené à l'état initial par chaque impulsion de remise à l'état initial (RS), qui en corrélation avec un cycle de rafraîchissement (5).

FIG 1

FIG 2

# FIG 3

# FIG 4